# EUROPÄISCHE PATENTANMELDUNG

(11) **EP 1 351 279 A1**
(43) Veröffentlichungstag der Anmeldung: **08.10.2003**
(21) Anmeldenummer: 02007561.0
(22) Anmeldetag: 03.04.2002
(51) Int. Cl.: H01L 21/00

(54) **Vorrichtung zum Transportieren von Substraten in einem Ofen**

(71) Anmelder: Esec Trading S.A., 6330 Cham (CH)
(72) Erfinder: Suter, Guido, 6312 Steinhausen (CH); Schmid, Reto, 6300 Zug (CH)
(74) Vertreter: Falk, Urs, Dr.

(57) **Zusammenfassung**

Die Erfindung betrifft eine Transportvorrichtung (4) zum Transportieren von Substraten (2) in einem Ofen (3). Der Ofen (3) weist einen durch einen Boden (10) und zwei Seitenwände (11, 12) gebildeten Kanal (9) auf, in dem die Substrate (2) in einer Transportrichtung (x') transportiert werden. Der Boden (10) des Kanals (9) weist eine entlang der einen Seitenwand (11) verlaufende Vertiefung (13) auf für die Aufnahme und Führung einer Schiene (14) in Transportrichtung (x'). Die Schiene (14) ist für die Aufnahme mindestens eines Substrates (2) eingerichtet. Ein Antriebssystem bewegt die Schiene (14) in Transportrichtung (x').

## Beschreibung

Die Erfindung betrifft eine Vorrichtung zum Transportieren von Substraten in einem Ofen der im Oberbegriff des Anspruchs 1 genannten Art.

Bei der Montage von Halbleiterchips ist es gebräuchlich, die Halbleiterchips, hauptsächlich Leistungshalbleiter, mit dem Substrat mittels Weichlötung zu verbinden, um über die Lötverbindung eine wirksame Ableitung der beim Betrieb entstehenden Verlustwärme aus dem Halbleiterchip zu gewährleisten. Die Bestückung der Substrate mit den Halbleiterchips erfolgt bei relativ hohen Temperaturen, bei denen das Lot aufgeschmolzen ist. An die Transportvorrichtung werden deshalb hohe Anforderungen gestellt.

Als Substrate werden vorwiegend metallische Substrate, sogenannte Leadframes verwendet, wo die Halbleiterchips auf hintereinander und, fakultativ, nebeneinander angeordneten Chipinseln aufgelötet werden. Das Leadframe wird taktweise einer Lotstation, wo das Lot aufgetragen wird, und dann einer Bondstation zugeführt, wo der Halbleiterchip von einem Pick and Place System auf dem flüssigen Lot plaziert wird. Das Leadframe weist entlang seiner Längskanten angeordnete Löcher auf, in die beim Transport des Leadframes Stifte eingreifen. Ein für diesen Prozess geeigneter Die Bonder wird von der Anmelderin unter der Bezeichnung 2007 SSI vertrieben.

Als Substrate kommen aber auch Einzelplatzsubstrate, sogenannte singulated substrates, zur Anwendung. Ein solches Einzelplatzsubstrat besteht beispielsweise aus einem Keramikplättchen, das beidseitig mit einer Metallschicht bedeckt ist. Die Montage der Halbleiterchips erfolgt manuell, wobei zuerst eine vorgeformte Lotportion, in der englischen Fachsprache als solder preform bekannt, auf das Einzelplatzsubstrat aufgelegt und dann der Halbleiterchip auf die Lotportion aufgelegt wird. Anschliessend wird der ganze Verbund in einem Ofen verlötet. Bekannt ist auch ein halbautomatisches Montageverfahren, bei dem anstelle einer vorgeformten Lotportion maschinell pastenförmiges Lot auf das Einzelplatzsubstrat aufgetragen wird. Anschliessend werden die Einzelplatzsubstrate manuell mit dem Halbleiterchip bestückt und wiederum in einem Ofen verlötet.

Als Substrate werden des weiteren beidseitig mit einer Metallschicht bedeckte Keramikplättchen verwendet, die mit einer Vielzahl von gleichen oder verschiedenen Halbleiterchips bestückt werden. Die Verarbeitung dieser Substrate erfolgt bei Kleinserien manuell. Die automatische Verarbeitung ist nur bei grossen Stückzahlen wirtschaftlich, da die bekannten Transportvorrichtungen für jedes Substrat individuell ausgelegt werden müssen.

Der Erfindung liegt die Aufgabe zugrunde, eine Transportvorrichtung zu entwickeln, die sich auf einfache Weise für die Verarbeitung unterschiedlicher Substrate einstellen lässt, so dass auch Kleinserien weitgehend automatisch verarbeitet werden können. Zudem soll sich die Transportvorrichtung auch für Einzelversuche im Labor eignen.

Die Erfindung besteht in den im Anspruch 1 angegebenen Merkmalen. Vorteilhafte Ausgestaltungen ergeben sich aus den abhängigen Ansprüchen.

Bei der Montage von Halbleiterchips auf einem Substrat durch Löten werden die Substrate in einem Ofen zu einer Lotstation, wo das Lot aufgebracht wird, und dann zu einer Bondstation, wo der Halbleiterchip auf das aufgeschmolzene Lot aufgebracht wird, befördert. Die Substrate werden dabei in einem durch einen Boden und zwei Seitenwände gebildeten Kanal in einer Transportrichtung transportiert. Erfindungsgemäss weist der Boden des Kanals eine entlang der einen Seitenwand verlaufende Vertiefung auf für die Aufnahme und Führung einer Schiene in Transportrichtung. Die Schiene ist für die Aufnahme mindestens eines Substrates eingerichtet. Ein Antriebssystem bewegt die Schiene in Transportrichtung. Wenn das Substrat ein Leadframe ist, dann kann das Leadframe an der Schiene angeschraubt oder klemmend befestigt werden. Für den Transport von Keramiksubstraten können an der Schiene quer zur Transportrichtung verlaufende Ausleger montiert werden, die die Keramiksubstrate aufnehmen.

Nachfolgend werden Ausführungsbeispiele der Erfindung anhand der schematisch und nicht massstäblich gezeichneten Figuren näher erläutert.

Es zeigen:
- Fig. 1: einen Die Bonder mit einem Ofen mit einer Transportvorrichtung in Aufsicht,
- Fig. 2: den Ofen und die Transportvorrichtung im Querschnitt entlang der Linie I-I der Fig. 1,
- Fig. 3: eine Schiene in seitlicher Ansicht,
- Fig. 4: die Schiene und ein Leadframe in Aufsicht,
- Fig. 5: eine Schiene mit Auslegern zum Transport von Keramiksubstraten,
- Fig. 6: die Ausleger und ein Keramiksubstrat im Schnitt entlang der Linie II-II der Fig. 5,
- Fig. 7: ein weiteres Beispiel des Zusammenwirkens der Ausleger mit dem Keramiksubstrat.

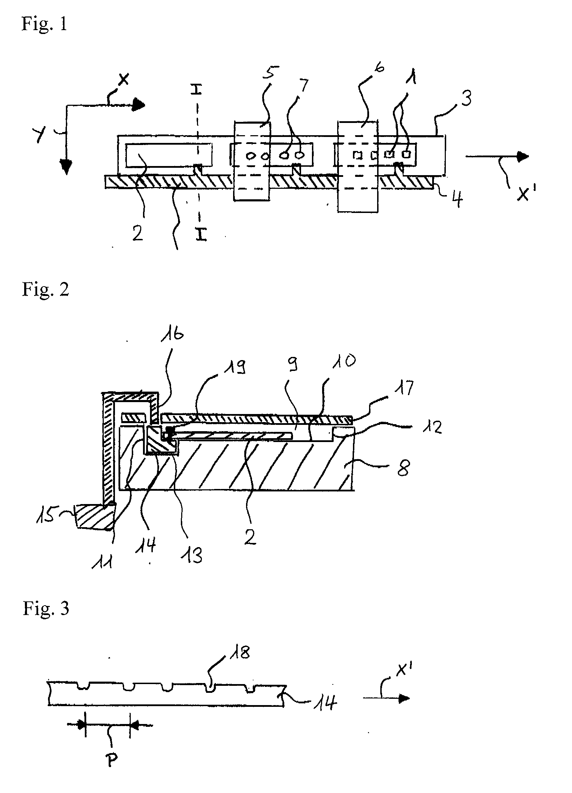

Die Fig. 1 zeigt schematisch und in Aufsicht einen Die Bonder für das Auflöten von Halbleiterchips 1 auf Substrate 2. Der Die Bonder umfasst einen in zwei horizontalen Richtungen x und y bewegbaren Ofen 3 mit einer Transportvorrichtung 4 für den Vorschub der Substrate 2 in einer Transportrichtung x', eine Lotstation 5 und eine Bondstation 6. Die Transportrichtung x' verläuft parallel zur Richtung x. Die Lotstation 5 dient zum Auftragen einer Lotportion 7 auf den an der Lotstation bereitgestellten Substratplatz, die Bondstation 6 dient zum Plazieren eines Halbleiterchips 1 auf dem an der Bondstation 6 bereitgestellten Substratplatz. In der Zeichnung sind die Lotportionen 7 aus rein zeichnerischen Gründen als Kreise dargestellt, während die Halbleiterchips 1 rechteckförmig gezeichnet sind. Die Substrate 2 werden manuell oder automatisch nacheinander zugeführt und von der Transportvorrichtung 4 taktweise in Transportrichtung x' durch den Ofen 3 transportiert. Bei jedem Takt werden die Substrate 2 um eine vorbestimmte Distanz P, im Fachjargon Pitch genannt, weitertransportiert. Im Ofen 3 wird mit nicht dargestellten Mitteln ein vorbestimmtes Temperaturprofil erzeugt. Die Distanz zwischen dem Prozesspunkt der Lotstation 5 und dem Prozesspunkt der Bondstation 6 beträgt ein ganzzahliges Vielfaches der Distanz P, so dass gleichzeitig an der Lotstation 5 eine Lotportion 7 aufgetragen und an der Bondstation 6 ein Halbleiterchip 1 aufgebracht werden kann.

Es gibt einerseits Substrate 2, bei denen pro Vorschub um die Distanz P nur ein Halbleiterchip 1 bestückt wird. Andererseits gibt es Substrate 2, bei denen pro Vorschub um die Distanz P mehrere Halbleiterchips bestückt werden. Bei diesen Substraten wird der Ofen 3 mitsamt der Transportvorrichtung 4 in x-und/oder y-Richtung bewegt, um die Substrate 2 bezüglich der Lotstation 5 und der Bondstation 6 richtig zu positionieren.

Die Fig. 2 zeigt die für das Verständnis der Erfindung relevanten Details des Ofens 3 und der Transportvorrichtung 4. Die Fig. 2 ist eine Schnittzeichnung entlang der Linie I-I der Fig. 1. Der Ofen 3 weist einen Ofenkörper 8 mit einem Kanal 9 mit einem ebenen Boden 10 und zwei Seitenwänden 11 und 12 auf, in dem die Substrate 2 vorwärts transportiert werden. Der Kanal 9 weist im Boden 10 eine entlang der ersten Seitenwand 11 verlaufende Vertiefung 13 auf. Die Vertiefung 13 dient als Führungsnut für die Führung einer beispielsweise L-förmigen Schiene 14. Die Schiene 14 nimmt ein Substrat 2 oder mehrere Substrate 2 auf. Die Transportvorrichtung 4 umfasst ein Antriebsystem 15, das mehrere, in einem ganzzahligen Vielfachen des Abstandes P angeordnete, heb- und senkbare Finger 16 aufweist, die im abgesenkten Zustand die Schiene 14 taktweise in Transportrichtung x' transportieren, wobei die Schiene 14 in der Vertiefung 13 geführt wird. Der Kanal 9 ist mit einer Abdeckplatte 17 zugedeckt. Die Abdeckplatte 17 berührt die Schiene 14 zwar nicht, verhindert aber, dass die Schiene 14 aus der Vertiefung 13 herausspringen kann. Die Abdeckplatte 17 weist Öffnungen für die Finger 16 auf.

Im Kanal 9 herrscht in der Regel eine Atmosphäre aus Schutzgas. Das Schutzgas kann wie beim Stand der Technik üblich zugeführt werden, z.B. durch im Boden 10 des Kanals 9 angebrachte Bohrungen.

Die Fig. 3 zeigt die Schiene 14 in seitlicher Ansicht. Die Schiene 14 weist im Abstand P angeordnete Vertiefungen 18 auf. Für den Vorschub der Schiene 14 werden die Finger 16 (Fig. 2) der Transportvorrichtung 4 abgesenkt, so dass sie in jeweils eine der Vertiefungen 18 der Schiene 14 eingreifen.

Im Beispiel der Fig. 2 ist das Substrat 2 ein metallisches Leadframe. Solche Leadframes bestehen in der Regel aus Kupfer. Die Schiene 14 ist aus einem Chromstahl gefertigt, der den gleichen thermischen Ausdehnungskoeffizienten wie das Leadframe hat. Das Leadframe kann auf verschiedene Arten an der Schiene 14 befestigt werden, beispielsweise mittels einer einzigen Schraube 19. Beim Aufheizen und Abkühlen im Ofen 3 ändern sich die Längen der Schiene 14 und des Leadframes mit unterschiedlicher Geschwindigkeit. Die Befestigung mit einer einzigen Schraube 19 gewährleistet, dass das Leadframe beim Aufheizen und Abkühlen frei von mechanischen Spannungen bleibt.

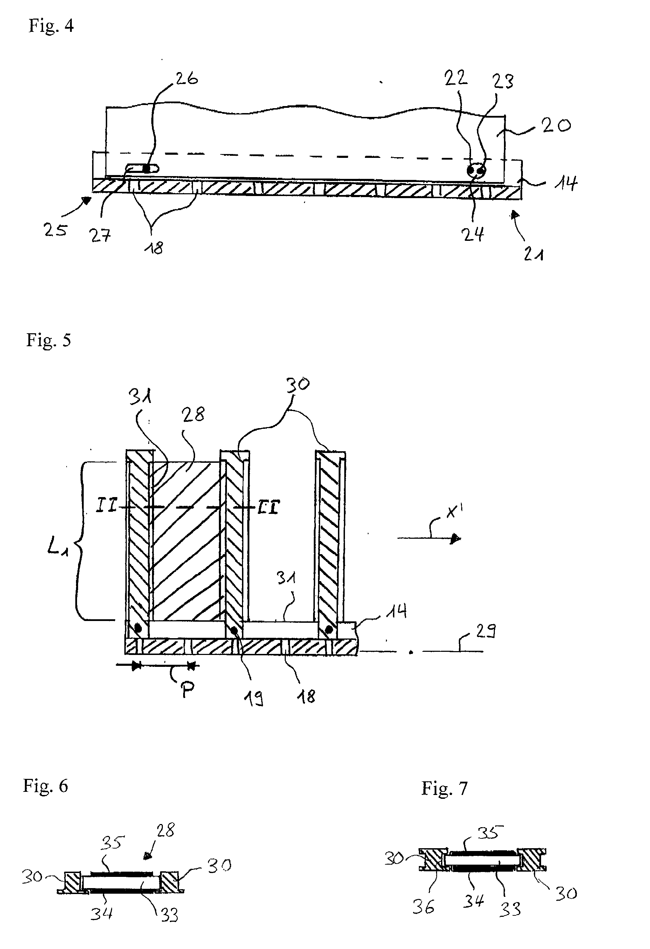

Die Fig. 4 zeigt in Aufsicht eine Lösung, bei der das Leadframe 20 klemmend an der Schiene 14 befestigt ist. Die inneren Strukturen des Leadframes 20 sind nicht gezeichnet. Die Schiene 14 weist z.B. an ihrem vorderen Ende 21 zwei Bolzen 22 und 23 auf. Deren Abstand ist so bemessen, dass das Leadframe 20 klemmend gehalten ist, wenn die Bolzen 22 und 23 in ein Loch 24 des Leadframes 20 eingreifen. Typischerweise ist das Leadframe 20 etwa 20 cm lang. Die Schiene 14 weist deshalb an ihrem hinteren Ende 25 mit Vorteil einen weiteren Bolzen 26 auf, der in ein weiteres, vorzugsweise längliches Loch 27 des Leadframes 20 eingreift. Der Bolzen 26 dient nicht zum Festklemmen, sondern nur zur Führung des Leadframes 20, damit seine Längskante an der Schiene 14 anliegt.

Falls der Pitch des Leadframes nicht mit dem Pitch der Transportvorrichtung übereinstimmt, dann kann das Leadframe in kleinere Einzelteile zertrennt werden. An einer Schiene 14 können dann mehrere solcher Einzelteile befestigt werden.

Die äussere Form der Schiene 14 kann problemlos dem Leadframe angepasst werden. So gibt es einerseits vollständig plane Leadframes, andererseits gibt es auch Leadframes, deren Längskanten gegenüber der Mitte erhöht oder abgesenkt sind.

Die Fig. 5 zeigt ein für Keramiksubstrate 28 geeignetes Ausführungsbeispiel der Schiene 14. Die Schiene 14 weist quer zu ihrer Längsachse 29 verlaufende Ausleger 30 auf, die im Abstand P oder einem ganzzahligen Vielfachen des Abstandes P angeordnet sind. Die Ausleger 30 können auf viele verschiedene Arten ausgebildet sein. Ihre Aufgabe besteht darin, zusammen mit der Schiene 14 die Keramiksubstrate 28 in einer definierten Lage aufzunehmen und in Transportrichtung x' zu transportieren. Bei dem in der Fig. 5 dargestellten Beispiel sind die Ausleger 30 mit entlang des Randes verlaufenden Ausnehmungen 31 versehen. Die Länge L₁ der Ausnehmungen 31 ist so bemessen, dass die Keramiksubstrate 28 von oben hineingelegt werden können und an einer Seitenwand 32 der Schiene 14 anliegen. Beim Transport liegen die Keramiksubstrate 28 auf den Auslegern 30 und, fakultativ, auf der Schiene 14 auf. Die Ausbildung der Ausleger 30 mit den Ausnehmungen 31 verhindert, dass die Keramiksubstrate 28 wegrutschen können. Die Breite der Ausleger 30 ist an die Breite der Keramiksubstrate 28 und den Abstand P angepasst. Die Ausleger sind z.B. mit Schrauben 19 an der Schiene 14 befestigt. Im Beispiel beträgt der Abstand zwischen zwei Auslegern 30 das Doppelte des Pitchabstandes P.

Die Fig. 6 zeigt im Schnitt entlang der Linie II-II der Fig. 5 ein zwischen zwei Auslegern 30 eingelegtes Keramiksubstrat 28. Das Keramiksubstrat 28 weist einen Körper 33 aus Keramik auf, der beidseitig mit metallischen Schichten 34 und 35 bedeckt ist. Die metallischen Schichten 34 und 35 lassen einen Rand des Körper 33 unbedeckt. Die Ausnehmungen 31 und der Abstand zwischen den Auslegern 30 sind so bemessen, dass nur der unbedeckte Rand des Keramiksubstrats 28 auf den Auslegern 30 aufliegt. Zudem ist die Dicke der Ausleger 30 im Bereich der Ausnehmungen 31 gleich der Dicke der metallischen Schicht 34 gewählt, so dass das Keramiksubstrat 28 auf dem Boden 10 (Fig. 2) des Ofens 3 aufliegt.

Die Fig. 7 zeigt in einem Schnitt analog zur Fig. 6 ein Beispiel, bei dem die Ausleger 30 eine Nut 36 aufweisen, so dass die Keramiksubstrate 28 von der Seite her eingeschoben werden können. Die Länge der Ausleger 30 ist so bemessen, dass ihre Endkante mit der Kante des Keramiksubstrats 28 bündig ist. Eine allfällige Lücke zwischen der Kante des Keramiksubstrats 28 und der Seitenwand 12 (Fig. 2) des Ofenkörpers 8 wird durch eine Platte ausgefüllt, so dass die Keramiksubstrate 28 nicht in y-Richtung (Fig. 1) wegrutschen können.

Die Erfindung ermöglicht die automatische Verarbeitung von Substraten, deren Breite geringer als die Breite des Kanals 9 des Ofens 3 ist. Zudem ermöglicht die Erfindung die Verarbeitung unterschiedlichster Typen von Substraten wie metallische Substrate und Kermiksubstrate.

## Patentansprüche

1. Transportvorrichtung (4) zum Transportieren von Substraten (2) in einem Ofen (3), wobei der Ofen (3) einen durch einen Boden (10) und zwei Seitenwände (11, 12) gebildeten Kanal (9) aufweist, in dem die Substrate (2) in einer Transportrichtung (x') transportiert werden, **dadurch gekennzeichnet, dass** der Boden (10) des Kanals (9) eine entlang der einen Seitenwand (11) verlaufende Vertiefung (13) aufweist für die Aufnahme und Führung einer Schiene (14) in Transportrichtung (x'), dass ein Antriebssystem vorhanden ist, um die Schiene (14) in Transportrichtung (x') zu bewegen, und dass die Schiene (14) für die Aufnahme mindestens eines Substrates (2) eingerichtet ist.

2. Transportvorrichtung (4) nach Anspruch 1, **dadurch gekennzeichnet, dass** die Schiene (14) eine Bohrung aufweist, um das mindestens eine Substrat (2) mittels einer Schraube (19) an der Schiene (14) zu befestigen.

3. Transportvorrichtung (4) nach Anspruch 1 oder 2, **dadurch gekennzeichnet, dass** die Schiene (14) mindestens einen Bolzen (22; 23) aufweist, der in ein Loch (24) in dem mindestens einen Substrat (2) eingreift und das Substrat (2) festklemmt.

4. Transportvorrichtung (4) nach einem der Ansprüche 1 bis 3, **dadurch gekennzeichnet, dass** die Schiene (14) Ausleger (30) aufweist, die das mindestens eine Substrat (2) aufnehmen.

5. Transportvorrichtung (4) nach einem der Ansprüche 1 bis 4, **dadurch gekennzeichnet, dass** die Schiene (14) Vertiefungen (18) aufweist, in die während der Transportphase Finger (16) des Antriebssystems (15) eingreifen.
